Europäisches Patentamt

(19) European Patent Office

Office européen des brevets

(11) Publication number:

**0 045 189**
**B1**

(12) **EUROPEAN PATENT SPECIFICATION**

(45) Date of publication of patent specification: **09.01.85**

(21) Application number: **81303393.3**

(22) Date of filing: **24.07.81**

(51) Int. Cl.⁴: **H 01 R 23/70, H 05 K 7/02, G 11 C 19/08**

(54) **Electrical connector arrangement.**

(30) Priority: **28.07.80 JP 103456/80**

(43) Date of publication of application:
**03.02.82 Bulletin 82/05**

(45) Publication of the grant of the patent:
**09.01.85 Bulletin 85/02**

(84) Designated Contracting States:
**CH DE FR GB IT LI NL**

(56) References cited:
**DE-A-2 229 543**
**GB-A-2 021 334**
**US-A-3 167 373**
**US-A-3 789 345**
**US-A-4 084 874**
**US-A-4 128 288**

(73) Proprietor: **FUJITSU LIMITED**
**1015, Kamikodanaka Nakahara-ku**
**Kawasaki-shi Kanagawa 211 (JP)**

(72) Inventor: **Tamura, Masayoshi**
**506-5, Yonamochi-machi**
**Suzaka-shi Nagano, 382 (JP)**
Inventor: **Matsumoto, Mitsuharu**
**95, Shimokodanaka**
**Kawasaki-shi Kanagawa, 211 (JP)**
Inventor: **Kinoshita, Ryohei**
**3-66, Minamihara**
**Suzaka-shi Nagano, 382 (JP)**
Inventor: **Sukeda, Toshiaki**
**406-3, Sakata-cho**
**Suzaka-shi Nagano, 382 (JP)**
Inventor: **Matsubayashi, Norio**
**1081-4, Oaza Kitanagaike**
**Nagano-shi Nagano, 380 (JP)**
Inventor: **Hirakawa, Osamu**
**507-1, Koku-machi**
**Suzaka-shi Nagano, 382 (JP)**

(74) Representative: **Sunderland, James Harry et al**
**HASELTINE LAKE & CO Hazlitt House 28**
**Southampton Buildings Chancery Lane**
**London WC2A 1AT (GB)**

Courier Press, Leamington Spa, England.

## Description

This invention relates to an electrical connector arrangement.

Electrical connection between two connector units is generally realised through close contact between respective electrical terminals of the two units — the one connector unit provides an electrical terminal in the form of a plug, whilst the other connector unit provides an electrical terminal in the form of a jack.

However, such slide contact type connector units cannot guarantee a long working life — a contact metallic layer formed by plating on an electrical terminal surface of a connector unit can easily be damaged and is readily worn away and such damage or wear results in the provision of a poor contact. Moreover, in a case in which many electrical terminals are provided in each connector unit, large insertion and withdrawal forces are required, resulting in a disadvantage in that it can be difficult to obtain desired electrical connection.

The use of a static pressure contact has been proposed as providing a zero insertion and withdrawal force contact method in which no wearing of metallic contact layers takes place. In such a method, no contact between a jack electrical terminal and a plug electrical terminal is obtained at the time of insertion, but only after insertion do the electrical terminals come into contact by a proccess involving moving one electrical terminal into contact with another electrical terminal.

Various kinds of contact pressure type arrangements have been proposed and put into practical use. They have been operationally inferior because the inserting operation, for inserting a plug connector unit, and the operation for causing electrical terminals to come into contact, are performed separately for those structures.

For example, a structure as explained below is well known as providing a pressure contact type coupling. In this structure, jack electrical terminals are initially maintained in an open condition by means of an ellipse-shaped member, and the jack electrical terminals are then placed in a closed condition, after a plug connector unit is inserted, by rotating the ellipse-shaped member using a knob, and thereby the jack comes into contact with the plug in a static or stationary fashion, without sliding motion between contacts.

With such a structure, an operator inserts the plug into the jack connector unit with one hand and thereafter must rotate the knob with the same hand or with the other hand, making connecting operations troublesome to execute.

An existing electrical connecting device for establishing connection between a bubble memory unit and a holder unit has a structure such that the electrical terminals of the two units are brought together through a sliding contact operation. A magnetic bubble memory may have many electrical terminals, for writing, propagating and reading bubbles, and therefore it has been difficult to provide that an existing bubble memory unit can accommodate a plurality of magnetic bubble memories from the point of view of insertion and withdrawal forces required to connect the bubble memory unit to, and disconnect it from, the holder unit. Particularly in the case of a magnetic bubble memory, the control of bubbles is performed using minute currents and therefore the existing electrical connecting device structure has a disadvantage in that misdetection and mis-generation of bubbles easily occur if a contact metallic layer of the electrical connecting device is worn.

GB—A—2 021 334 discloses an electrical connector arrangement comprising a cartridge on which electrical terminals are provided, and a base unit with an enclosure unit mounted freely rotatable thereon for holding the cartridge. Electrical terminals are provided in an aperture in the base unit. The enclosure is normally disposed substantially outside the base unit and has a mouth through which the cartridge is inserted into the enclosure. After insertion, rotation of the cartridge, in the enclosure, in a direction substantially at a right angle to the direction of insertion rotates the enclosure unit with the cartridge into the aperture in the base unit and brings about pressure contact between the electrical terminals on the cartridge and base unit. A locking mechanism is provided to lock the cartridge in this disposition, and a push button is provided to unlock the cartridge.

US—A—3 789 345 discloses the use of shaped grooves for guiding one member with respect to another.

According to one aspect of the present invention, as set out in Claim 1, there is provided an electrical connector arrangement, comprising a first connector unit, which is a cassette type unit on which electrical terminals are provided, and a second connector unit, which is a holder unit, for holding the first connector unit, in which electrical terminals are provided, the second unit having a mouth into which the first unit is inserted for establishing connection of electrical terminals of the first and second units, the arrangement being such that after insertion into the mouth of the second unit rotation of the first unit in a direction substantially at right angles to the direction of insertion brings about pressure contact between electrical terminals of the first and second units, the second unit having a freely rotatable accommodation case, into which the first connector unit enters and is accommodated upon insertion into the second connector unit, which case rotates with the first connector unit when pressure contact between electrical terminals of the first and second unit is being brought about, a locking mechanism adapted to lock the accommodation case in position in the second unit when pressure contact between electrical terminals is brought about, and a push button on the second unit operable to unlock the first unit, characterised in that the freely rotatable accommodation case lies wholly within the second connector unit and rotates relative to the mouth of the second connector unit, the first and second units being so adapted that when accommodated in the accommodation case, ready for rotation, a portion of the first unit projects out of the mouth of the second unit for manipulation to bring about rotation of the first unit.

A second aspect of the invention, as set out in Claim 13, relates to the second connection unit itself.

An embodiment of the present invention can provide an electrical connector arrangement wherein the disadvantage of previous proposals are substantially overcome and which can assure stable and reliable electrical connection, with excellent operationability, in an electrical connector arrangement in which a first connector unit is inserted into an accommodation case of a second connector unit, and thereby electrical terminals of the connector units are connected.

An embodiment of the present invention can provide an electrical connector arrangement that can assure excellent operationability for the electrical connection of a bubble memory unit and which can also provide stable and reliable electrical connection in an electrical connection system in which a first connector unit consists of a cassette type of magnetic bubble memory unit and a second connector unit consists of an accommodation case for accommodating the bubble memory unit.

Reference is made, by way of example, to the accompanying drawings, in which:—

Figure 1 is a circuit diagram of an example of a cassette type magnetic bubble memory system in connection with which embodiments of the present invention can be employed,

Figure 2 is a perspective view of a cassette type magnetic bubble memory unit as previously proposed by the present applicant in United States Patent Application No. 192,804,

Figure 3 is a perspective view of the previously proposed cassette type magnetic bubble memory unit and a holder unit therefor, before establishment of electrical connection therebetween,

Figure 4 is a schematic side view indicating in principle the structure of a cassette type magnetic bubble memory unit in accordance with an embodiment of the present invention,

Figure 5 is a side sectional view indicating in principle the structure of a holder unit in accordance with an embodiment of the present invention, for use with the unit of Figure 4,

Figure 6 is a side sectional view indicating, in principle, the condition of an embodiment of the present invention when the bubble memory unit of Figure 4 is inserted into the holder unit of Figure 5,

Figure 7 is a side sectional view indicating, in principle, the condition of the embodiment of the present invention shown in Figure 6, when electrical connection is established between the bubble memory unit and holder unit,

Figure 8 is a perspective view of a bubble memory unit and a holder unit, in accordance with an embodiment of the present invention, before they are electrically connected,

Figure 9 is an exploded view indicating the structure of a holder unit (disassembled) in accordance with an embodiment of the present invention,

Figure 10 is a side view of a coil spring for lock level recovery, employed in the holder unit of Figure 9,

Figure 11 is an exploded perspective view of a mounting portion for establishing a lock level, employed in the holder unit of Figure 9,

Figure 12 is a plan view for assistance in explanation of lock level establishment in the holder unit of Figure 9,

Figure 13 is a side view of a bubble memory unit accommodation case of the holder unit of Figure 9,

Figure 14 is a view from the rear of a holder case of the holder unit of Figure 9,

Figure 15A is a side sectional view illustrating the condition of the holder unit of Figure 9 when a bubble memory unit is inserted thereinto,

Figure 15B is a partial front view of the holder unit of Figure 9 when in the condition shown in Figure 15A,

Figure 16A is a side sectional view illustrating the condition of the holder unit of Figure 9 when the bubble memory unit and holder unit shown in Figures 15A and 15B are electrically connected,

Figure 16B is a partial front view of the holder unit of Figure 9 when in the condition shown in Figure 16A,

Figure 17 is a perspective view of a bubble memory unit and a holder unit in accordance with another embodiment of the present invention, before they are electrically connected,

Figure 18 is an exploded perspective view of the bubble memory unit (disassembled) of Figure 17,

Figure 19A illustrates in more detail the disposition of a slide plate employed for setting a bubble information write-inhibit state or a write-allow state in the bubble memory unit of Figure 18, and is more particularly a plan view illustrating the disposition of the slide plate in a write-inhibit state,

Figure 19B is a sectional view taken along the line a—a' of Figure 19A,

Figure 20A is a plan view illustrating the disposition of the slide plate in a bubble information write-allow state,

Figure 20B is a sectional view taken along the line a—a' of Figure 20A,

Figure 21 is a schematic side sectional view of the bubble memory unit of Figure 17, illustrating a closed condition of an electrical terminal protection cover of the bubble memory unit,

Figure 22 is a schematic side sectional view illustrating an open condition of the protection cover of Figure 21,

Figure 23 is an exploded perspective view of the holder unit (disassembled) of Figure 17,

Figure 24A is a perspective view of the connectors carrying the electrical terminals of the bubble memory unit and the holder unit of Figure 17, and

Figure 24B is a side sectional view taken along the line a—a' of Figure 24A.

Embodiments of the present invention will be described in the context of a cassette type magnetic bubble memory system.

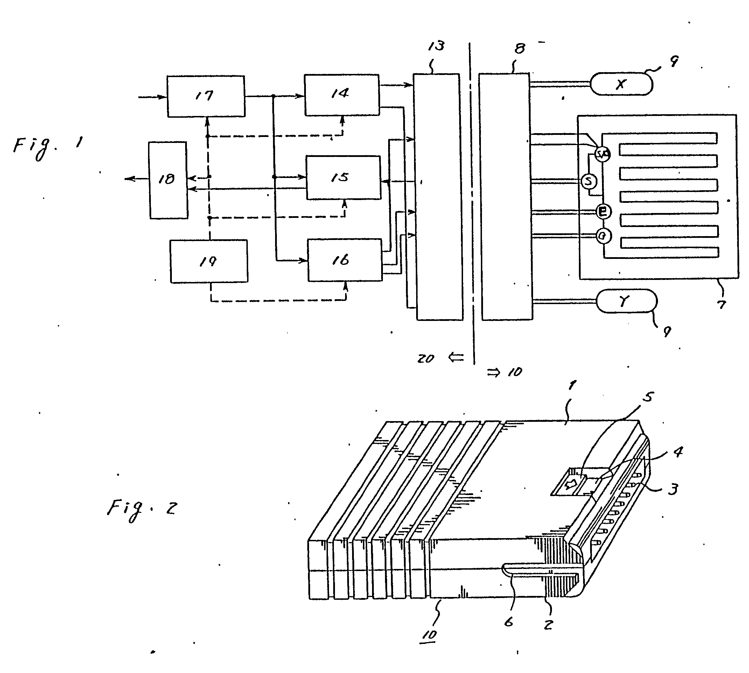

Figure 1 is provided for the purpose of explanation of an example of circuit structure of a cassette type magnetic bubble memory system.

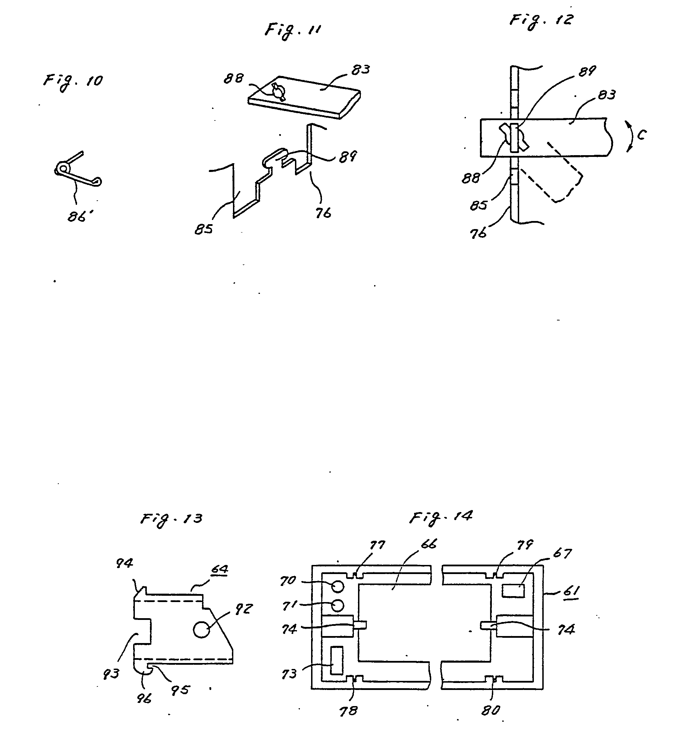

In Figure 1, 10 is a cassette type magnetic bubble memory unit, and 20 is a holder unit, which is a terminal part of a main apparatus which is to receive the bubble memory unit.

In addition, 7 is a bubble memory chip comprising functional blocks such as a magnetic bubble generator G, a divider SB, a detector S and an eraser E. In Figure 1, the bubble memory chip 7 is shown as providing a single loop structure, but a bubble memory chip providing a major/minor loop structure also has functional blocks as indicated in Figure 1.

8 is a connector of the bubble memory unit, providing electrical terminals. 9 is a rotating field generation coil consisting of an X-coil and a Y-coil provided in such a way as to cover the bubble chip 7. The magnetic bubble memory element is composed of the bubble chip 7, the coil 9 and a bias magnet etc, packaged in a shielding case.

13 is a connector of the holder unit 20, providing electrical terminals corresponding to those of connector 8 on the side of the bubble memory unit 10. 14 is a coil driver circuit for generating a rotating field along the bubble chip surface by supplying a sine wave current or a triangular wave current etc, 15 is bubble read circuit, 16 is a magnetic bubble control circuit comprising a bubble writing circuit for generating bubble by feeding current to the bubble generator G, a circuit for dividing bubbles by feeding current to the divider SP, a circuit for detecting the existence of bubbles by feeding a current to detector S, and a circuit for erasing unwanted bubbles by feeding a current to eraser E. 17 is a control circuit which controls the coil driver circuit 14, bubble read circuit 15 and bubble controller 16 in accordance with command signals issued from a central processing unit. 18 is a register and 29 is a current circuit.

Such a structure allows the comparatively small capacity and portable bubble memory unit 10 to be connected as required to the holder unit 20 via the connectors 8 and 13, and the bubble memory element in the unit 10 to be driven via the holder unit 20 in accordance with the control signals issued from the main apparatus.

In the case of a conventional bubble memory unit as shown in Figure 2, the magnetic bubble memory element (not illustrated in Figure 2) is accommodated within upper and lower moulded box type case parts 1 and 2 as shown in Figure 2, and a plurality of slide contact type electrical terminals 3 forming the connector 8 (refer to Figure 1) are provided at an inserting terminal portion of the memory unit.

The upper case part 1 has an indentation 4 on its outer surface at the inserting terminal portion thereof, and provided within the indentation 4 is a freely slidable slide plate 5, the position of which sets either a bubble information write-inhibit state or a write-allow state.

The upper case part 1 and the lower case part 2 when together provide guide grooves 6 on opposite sides of the case (only one side shown in Figure 2). The grooves have different widths, for preventing mis-insertion.

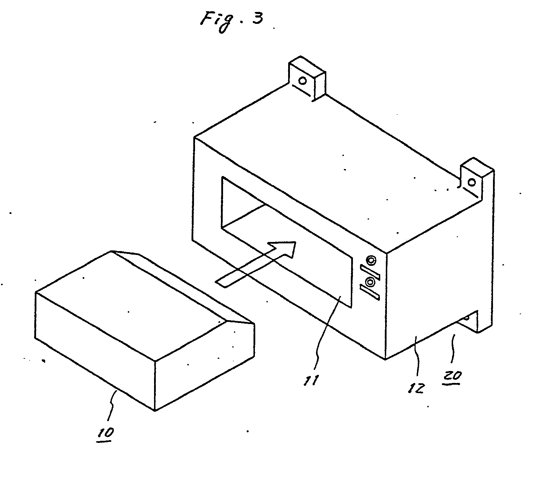

As shown in Figure 3, a conventional holder unit 20 has a moulded type holder case 12 having a bubble memory inserting mouth 11, and the case can be mounted on a panel surface of a main apparatus. To the rear of the inserting mouth 11, a connector (not illustrated), providing spring electrical terminals, corresponding to the electrical terminals 3 of the memory unit, and a printed circuit board, mounting a bubble control circuit, are provided.

Conventionally, the bubble memory unit 10 is inserted into the inserting mouth 11 and thereby electrical connection is obtained through sliding contact between electrical terminals of the two units 10 and 20. However, this conventional connection system or connector arrangement has a disadvantage in that the force of insertion and withdrawal can be as high as several kilograms, degrading operationability when a bubble memory unit is to be replaced, and the contact pressure during sliding contact insertion and withdrawal can cause the surfaces of electrical terminals to be damaged, shortening the life of the contacts. Since a bubble memory element is driven by minute currents, unstable contact arising from such damage can cause erroneous writing or erasing of bubble information, which may represent a serious problem for the cassette type bubble memory system.

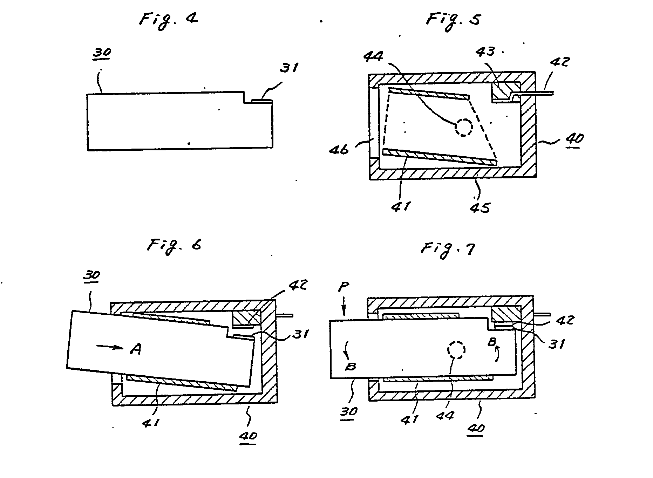

Figures 4 to 7 illustrate the basic structure of and basic operations of an embodiment of the present invention.

Figure 4 illustrates the structure of a bubble memory unit, in accordance with an embodiment of this invention, and Figure 5 illustrates the structure of a holder unit in accordance with an embodiment of this invention. Figure 6 illustrated conditions when the bubble memory unit is initially inserted into the holder unit, and Figure 7 illustrates conditions when the inserted bubble memory unit is rotated and electrically connected to the holder unit.

In Figure 4, a cassette type bubble memory 30, comprising a bubble memory element, is provided with an exposed contact surface carrying a plurality of electrical terminals 31 on a rear upper surface part of the end of the unit which is inserted. The electrical terminals 31 are connected as required to the bubble memory element (not illustrated) in the unit 30.

On the other hand, the holder unit 40 provides a unit accommodation case 41 shaped for receiving the unit 30, and a connector 43 carrying a plurality of fixed electrical terminals 42. The unit accommodation case 41 is freely rotatably supported within a holder case 45 of the holder unit 40, on bosses 44 on both right and left side walls of the holder case.

One end of each electrical terminal 42 is guided away from the connector 43 and projects backwardly of the case 45; the other end of each terminal 42 has an exposed contact surface facing downwards inside and at the rear of case 45. The case 45 also provides memory unit insertion mouth 46.

Connecting operations for establishing connections between units 30 and 40 are performed as follows.

First, as shown in Figure 6, the unit 30 is inserted into the accommodation case 41 through the insertion mouth 46, in a direction along arrow marked A. At this time, the accommodation case 41 is held in an inclined position as shown in Figure 6, so that the rear portion of case 41 is rotated downwards. Therefore, in the completely inserted condition shown in Figure 6, the plurality of electrical terminals 31 on unit 30 and fixed electrical terminals 42 on the unit 40 are in opposition, with corresponding contact surfaces spaced apart in an upward and downward direction.

Then, when a pressure P is applied to the upper surface of the front side of the unit 30, as indicated, the unit 30 rotates in the direction indicated by arrow marked B in Figure 7, together with the accommodation case 41, and corresponding contact surfaces of the electrical terminals 31 and fixed electrical terminals 42 come into pressure contact, making it possible to send electrical signals to and receive electrical signals from the bubble memory element comprised in the unit 30. Each of the electrical terminals 31 or each of the electrical terminals 42 is of an elastic or flexible resilient structure.

The unit 30 shown in Figure 4 has electrical terminals 31 exposed at an upper rear surface portion thereof (and fixed terminals 42 are positioned accordingly). Alternatively, the terminals 31 may be mounted on a lower front surface portion of unit 30. However, in this case, the fixed electrical terminals must be provided so that they can oppose the electrical terminals located at the lower front surface portion of the unit 30, when unit 30 is within the unit 40, and the axis of rotation of the accommodation case 41 must be set at the rear of the unit 40, rather than as shown in Figure 5.

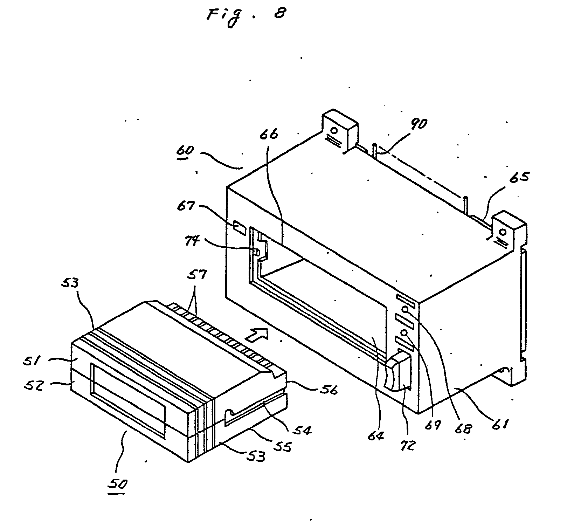

Figure 8 is a more detailed illustration of an embodiment in accordance with the basic structure shown in Figures 4 and 7.

In Figure 8, a bubble memory unit 50, comprising a bubble memory element, has upper and lower case parts 51 and 52, of a moulded insulating resin material. At an upper rear surface portion of an end of the upper case 51 which is to be inserted into a holder unit, electrical terminals 57 are mounted with their contact surfaces exposed. In addition, on both right and left side surfaces 53 of the case formed by case parts 51 and 52, L-shaped grooves 54 are formed. Each groove 54 has a part almost or substantially linear and parallel to a lower surface 55 of the lower case part 52. One end of each groove 54 is open towards a rear surface 56 of the unit 50, whilst the other end of each groove 54 is bent upwards, the upward bend being roughly central of the side surface 53 in which the groove is provided.

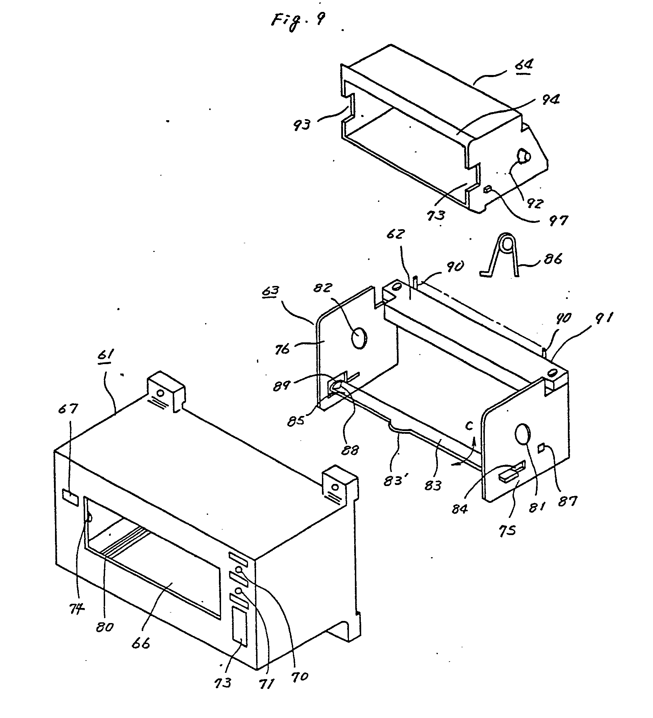

The holder unit 60 is composed, as shown in more detail in the exploded perspective view of Figure 9, of a holder case 61, consisting of a moulded insulated resin material, a holder bracket 63 comprising a connector (with electrical terminals thereon), a unit accommodation case 64, of a moulded insulating resin material, and a rear plate 65.

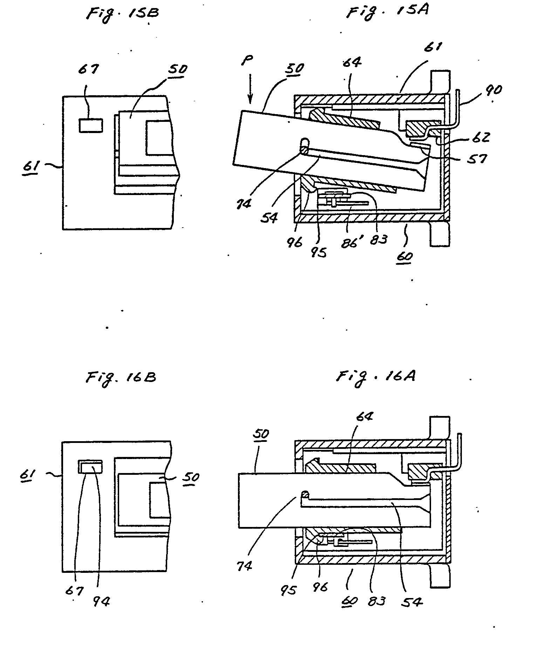

With reference also to Figure 14, it will be seen that the box type holder case 61 provides an insertion mouth 66 of the unit 50, a through window 67, through holes 70 and 71 for mounting light-emitting diodes 68 and 69 for indicating memory unit insertion condition and rotating operation completion condition, and a through hole 73 for mounting a push button 72 for releasing a locked condition of the unit 50. The case 61 has a pair of rounded projections 74 which respectively project inwardly of the case from opposite, right and left, sides of the case, within the insertion mouth 66, and also provides groove pairs 77 to 80 for guiding and supporting side plates 75 and 76 of bracket 63 (Figure 9), the groove pairs being arranged on upper and lower internal surfaces of the case 61, face to face vertically.

The holder bracket 63 has a generally U-shaped structure wherein side plates 75 and 76, respective metal plates, are combined with the connector 62. The side plates 75 and 76 have respective through holes 81 and 82 for freely rotatably supporting the accommodation case 64, and respective through holes 84 and 85 for mounting a lock lever 83. In addition, one side plate 75 provides an inwardly directed projection 87 for supporting one end of a coil spring 86.

Opposite ends of the lock lever 83 are located in respective through holes 84 and 85. The lock lever 83 is mounted at one end in through hole 85, in such a way that it can freely rotate about that one end in through hole 85, and is freely slidably mounted at its other end in the through hole 84. As a result, the lock lever is mounted in such a manner that the end thereof in through hole 84 can freely sway in the directions indicated by arrow mark C, about a centre provided by the end thereof mounted in through hole 85, when backward pressure is applied to the end in the through hole 84. The lock lever 83 is always subject to forward pressure because the coil of coil spring 86 is inserted into the T-shaped projection (refer to Figure 11) and its ends are engaged with the lock lever 83 and the side plate 76. Free rotation of the one end of the lock lever 83 in through hole 85 is realised by a structure such that a T-shaped projection 89, formed in the through hole 85, is inserted, as shown in Figures 11 and 12, into a through hole 88 provided with a groove as shown, at the one end of the lock lever 83 in through hole 85.

The connector 62 is provided, in correspondence with the electrical terminals 57 of unit 50, with a corresponding plurality of fixed electrical terminals 90. One end of each electrical terminal 90 is exposed at a lower surface of a connector moulding 91, whilst the other end of each terminal 90 is projected upwardly, by bending.

As shown in Figure 13, also, the unit accommodation case 64 provides bosses 92 at regions a little to the rear of the centres of the right and left side walls of case 64, and also provides grooves 93, which avoid the projections 74, at the fronts of the two side walls. The case 64 provides a projection 94 at an upper front region thereof, and a projection 96, which forms a backward-opening engaging groove 95, at a lower front region thereof. In addition, a projection 97, with which one end of coil spring 86 is engaged, is provided on one side wall of the case 64.

Operations for establishing electrical connection between the bubble memory unit 50 and holder unit 60 will now be explained.

When the unit 50 is inserted into the inclined case 64 as shown in Figures 15A and 15B, the unit 50 is inserted into the case 61 through the insertion mouth 66 and is guided by engagement between grooves 54 on unit 50 and projections 74 on case 61.

The projections 74 collide with the bent up part of the grooves 54 and stop, as shown in Figure 15A, completing insertion operations for the unit 50. In this case, as shown in Figure 15A, electrical terminals 57 of the unit 50 and electrical terminals of unit 60 are respectively in vertical opposition.

When a pressure P is applied to the forward end portion of unit 50 that projects from the unit 60, the unit 50 and the case 64 rotate around the axis provided by bosses 92. This results in pressure contact between the electrical terminals 57 and 90. At this time, the projection 96 of case 64 comes into contact with a forward projection 83' (refer to Figure 9) of the lock lever 83, and the lever 83 is pushed backwards by the curved surface of the projection 96. Thereafter, the lever 83 returns forward due to the spring force of coil spring 86' and drops into engagement in the engaging groove 95 of case 64. Simultaneously, projections 74 engage with the upwardly bending portions of grooves 54 and thereby the unit 50 is completely inserted.

This condition is shown in Figure 16A and 16B. The unit 50 and unit 60 are locked together through engagement between upwardly bending portions of grooves 54 and projections 74, and engagement between the groove 95 of case 64 and projection 83' of lever 83. In such a condition, the unit 50 projects forwardly and is prevented from returning to the inclined attitude (used when initially inserting it) shown in Figure 15A.

Moreover, the projection 94 of case 64, which is higher than the window 67 in the case 61 and is thus hidden when the condition shown in Figure 15B is established, now comes into direct sight through the window 67 in the condition shown in Figure 16B. Thereby, insertion of the unit 50 can be confirmed.

The surface of projection 94 may be painted with brightly coloured paint, or engraved with letters such as SET etc, so that insertion of the unit 50 can be confirmed more obviously.

The contact pressure of an electrical terminal 57 and a fixed electrical terminal 90 is generally selected to be about 100 g in order to obtain further reliable contact characteristics. For example, therefore, in a case in which there are 28 electrical terminals 57 and a similar number of fixed electrical terminals 90, the total contact pressure is about 3 kg.

This embodiment of the present invention utilises the following principle:— For example, the distance between a boss 92 and terminals 90 (and terminals 54 when unit 50 is inserted as shown in Figure 15A) is taken to be L, whilst the distance between boss 92 and the point at which pressure P is applied (see Figure 15A) is taken to be 3L, so that the pressure P required is about 1 kg, which represents a drastic reduction over the total contact pressure of 3 kg.

The inserted unit 50 can be removed from the unit 60 through the following operations. Namely, when the push button 72 is pushed by the fingertip, the end of the push button 72 inside the case 61 is so arranged as to move backward the end part of the lever 83 which projects outside of the side plate 75. As a result, engagement between the lever 83 and case 64 is released and simultaneously the case 64 returns to the inclined condition shown in Figure 15A due to the spring force of the coil spring 86. The unit 50 can then be pulled out of the unit 60.

The embodiment of the present invention explained above attains stable contact between electrical terminals in such a way as to greatly increase operating life, and requires lesser force to establish contact than the required contact pressure between the corresponding electrical terminals. Moreover, this embodiment offers some excellent practical benefits; namely the unit 50 can be inserted using only one hand, electrical connection can be established merely by rotation, and total operation is fully simplified. The lock mechanism, which locks the unit 50 when inserted, has advantages in that it provides for stability of contact pressure between electrical terminals and is simple in structure. Moreover, the embodiment also provides an advantage in that the fully inserted condition of unit 50 can easily be confirmed visually through the small window 67 provided at the front side of receiving unit 60.

Thus, the electrical connecting device above, embodying the present invention, offers practical advantages such as highly reliable electrical connection, simple operations for achieving unit insertion/withdrawal and electrical connection/disconnection, and, moreover the simple structure used assures economical production. production.

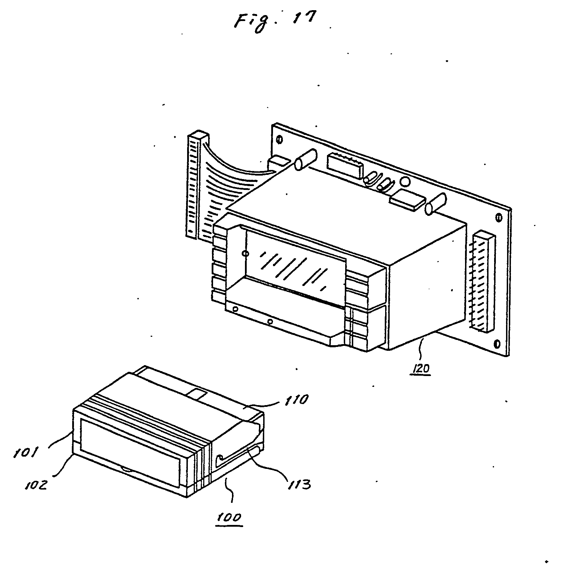

Now, a second embodiment of the present invention will be described with reference to Figures 17 to 24.

In Figure 17, a bubble memory unit 100 differs from the unit 50 of the first described embodiment particularly in that a cover 110, which can close over electrical terminals of the unit, for protection of the electrical terminals, is provided. Holder unit 120 in Figure 17 is different from the unit 60 particularly in that a cover 130, which can close over and cover the insertion mouth, is provided.

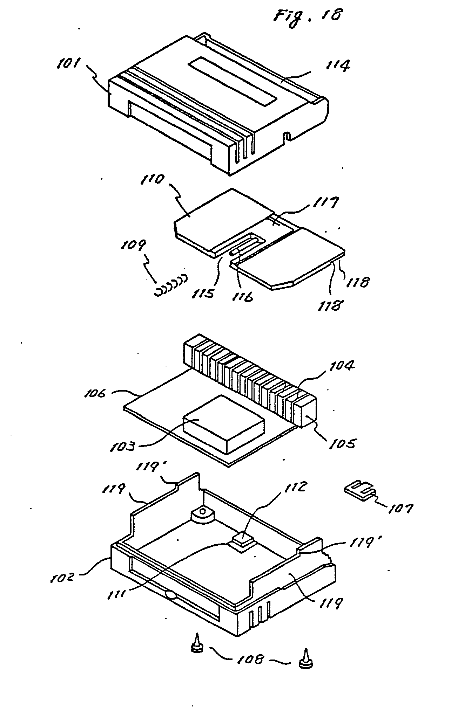

First, the structure of unit 100 will be explained with reference to Figures 18 to 22.

The unit 100 has upper and lower case parts 101 and 102, of moulded insulating resin material, printed circuit board 106 mounting magnetic bubble memory element 103, and connector 105 providing electrical terminals 104, generally E-shaped slide plate 107, of insulating resin material, for setting either a bubble information write-inhibit state or a write-allow state, screws 108 for bringing case parts 101 and 102 together, coil spring 109, and plate cover 110, of moulded insulating resin material.

The unit 100 comprises the slide plate 107 between a dent or indentation 111 and a projection 112 of the lower case part 102, and accommodates the PC board 106 and the cover 110. The upper case part 101 is fixed by screws 108.

In this case, generally L-shaped grooves 113 are formed at the sides of the case as in the embodiment shown in Figure 17. The connector 105 is located at a window 114 formed in the upper case part 101 towards the rear of the upper case part 101 which is inserted into the unit 120, and electrical terminals 104 of the connector 105 can be seen from outside the unit 100 when the cover 110 is opened. The cover 110 has a cut-away part 115 at its centre, and has a pin 116, on which the coil spring 109 is fitted, in the cut-away part. Moreover, at the centre of the upper surface of cover 110, a projection 117 is formed, whilst at the rear of the lower surface of cover 110, a recessed surface 118 is formed. The cover 110 is freely slidably supported between upper surfaces of right and left side plates 119 of the lower case part 102, and the internal surface of the upper case part 101, and usually a recess part 118' of the recessed surface 118 and lips 119' of the side plate 119 come into contact with each other by means of the spring force of the coil spring 109. In this condition, the window 114 is closed over by the rear part of cover 110 and thereby the connector 105 cannot be seen from the outside.

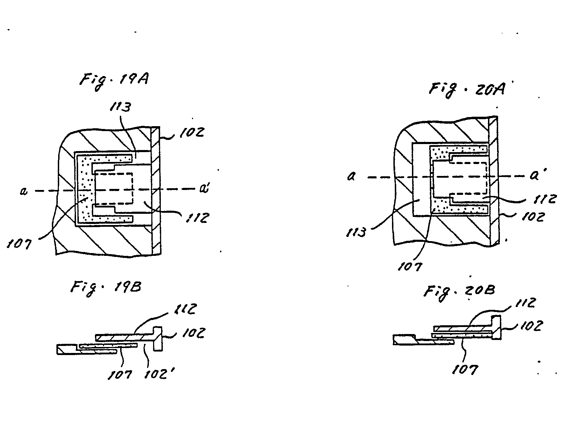

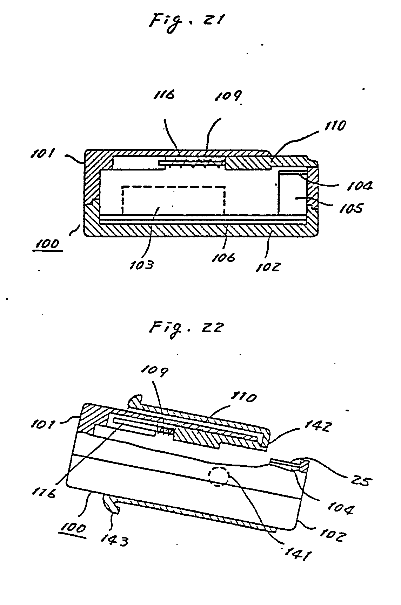

Figures 19 and 20 illustrate operations of slide plate 107.

In Figures 19A and 19B, the slide plate 107 is shown in an "open" condition and resultingly an indentation 102' is formed between the bottom of the lower case part 102 and the end of the plate 107. The presence of this indentation can be detected and used to provide a bubble information write-inhibit state signal. The indentation can for example, be detected by a switch (not illustrated) provided within the unit 120.

In Figures 20A and 20B, the slide plate 107 is shown in a "closed" condition — no indentation 102' is provided and thereby a bubble information write-allow state signal can be obtained.

Figures 21 and 22 explain opening and closing operations of the cover 110.

The unit 100 as shown in Figure 21 is in a condition prior to insertion into holder unit 120. The cover 110 is closed by the spring force of coil spring 109 and the electrical terminals 104 cannot be seen.

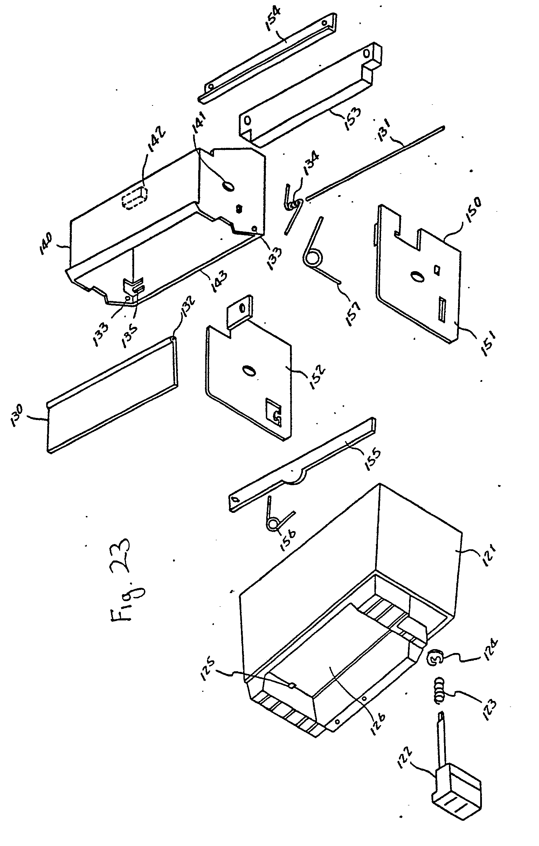

When the unit 100 in this condition is inserted into the unit accommodation case 140 (refer to Figure 23) of the holder unit 120 then, as explained in detail later, as shown in Figure 22, the projection 117 of the cover 110 is engaged by a projection 142 (refer to Figure 23) provided on the inside of the rear part of the case 140, and as a result the cover 110 is automatically opened when the unit 100 is inserted. In this condition, electrical terminals 104 are exposed in the window 114 and the same operations as those described in Figure 16 establish electrical connection with electrical terminals on the holder unit.

When the unit 100 is withdrawn, the cover 110 is automatically set to the closed condition by means of the coil spring 109.

The structure of holder unit 120 of the second embodiment of the present invention will now be explained with reference to Figures 17 and 23.

The Unit 120 is similar to the unit 60 of the first described embodiment from the structural point of view. Namely, a holder case 121 provides a push button 122 for operating a lock lever (a coil spring 123 for push button recovery, and a ring 124 for preventing removal of the push button are also provided), projections 125, for guiding the unit 100 during the insertion, and a unit insertion mouth 126. The unit accommodation case 140 provides bosses 141, and a projection 142, for opening the cover 110, formed on the internal surface of the upper wall of the case 140, and a projection 143 is provided at the lower front region for engagement with lock lever 155. The holder bracket 150, for freely rotatably supporting the case 140, has right and left side plates 151 and 152, a connector 153, comprising electrical terminals, for connecting the side plates 151 and 152, a connector clamping plate 154, the lock lever 155, which swings around one end thereof, a coil spring 156 for lock lever recovery, and a coil spring 157 for unit accommodation case recovery. The cover 130 which is a characteristic of this unit 120 is of moulded insulating resin material and has a through hole 132 through which an axle 131 passes. For mounting the cover 130, the case 140 has through holes 133 in which the axle 131 is mounted on the right and left side walls. The case 140 has a projection 135 for mounting twisted coil spring 134 for pushing forward the cover 130. The cover 130 can be mounted on the case 140 by, first, inserting the coil part of coil spring 134 onto the projection 135 and then engaging one end of the spring with the side wall. Then, the cover is mounted on the case 140 with the axle 131 in the through holes 132 and 133.

The cover 130 in such condition would fall open to the front because the other end of the coil spring 134 engages with the cover 130. However, when the case 140 is mounted within the case 121, the cover 130 is held back by the projection 125 and does not fall open to the front, and the insertion mouth 126 of the case is closed by the cover 130. Usually the cover 130 closes over the insertion mouth by means of the action of the coil spring 134, but when the unit 100 is inserted into the insertion mouth 126, the cover is pushed down onto the upper surface of the bottom plate of case 140. When the unit 100 is withdrawn, the cover 130 re-closes the insertion mouth 126 through the action of the spring force of the coil spring 134.

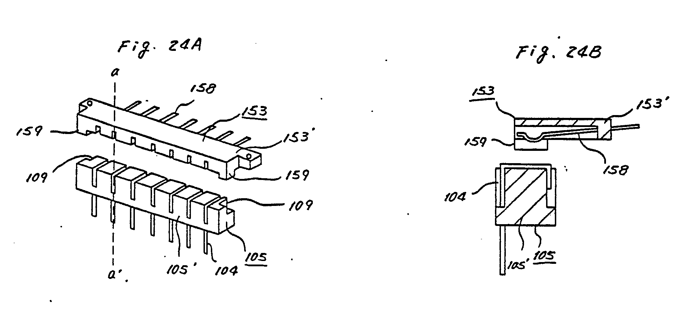

Figures 24A and 24B show the connector 105 in the unit 100 and connector 153 in the unit 120. The electrical terminals 104 of the connector 105 are of a U-shaped form, and are mounted in a connector moulding 105'. In the case of connector 153, spring electrical terminals 158 are mounted on connector moulding 153'. Rotation of unit 100 (see Figures 16A and 16B) causes the connector 105 to move upward, thereby establishing electrical connection between electrical terminals 104 and 158. In this case, in this embodiment, an indentation 109 is formed on one of the connector mouldings 105' and 153', and a projection 159 is formed on the other of those mouldings, and positioning is performed by engagement of the indentation 109 and projection 159, and electrical connection is set up by means of pressure contact between electrical terminals 104 and 158.

In addition to advantages similar to those provided by the first embodiment described above, the second embodiment described above can offer further advantages such as prevention of accumulation of duts on contact surfaces of electrical terminals, prevention of damage to contact surfaces due to carelessness, and can ensure highly reliable electrical connection, by the provision of the cover over the electrical terminals of the unit to be inserted. In addition, the opening and closing cover provided for the unit insertion mouth of the receiving unit can offer further reliable electrical connection. Moreover, the connectors carrying the electrical terminals of the two units are positively positioned at the time of connection, and therefore positional deflection cannot be generated and reliable electrical connection can thus be realised.

Moreover, both of the opening and closing covers open and close automatically upon insertion and withdrawal of the unit to be inserted, and thereby operations are very simple.

In the second embodiment described above, electrical connection between units is established by inserting one unit and then rotating that unit, which is the same operation as that disclosed in Figures 15 and 16 for the first embodiment.

An electrical connecting device embodying the present invention can be provided in which the first connector unit is magnetic bubble memory unit, and the second connector unit is a holding unit for accommodating the bubble memory unit.

The present invention can provide stable and reliable electrical connection between units with excellent insertion operationability.

**Claims**

1. An electrical connector arrangement comprising a first connector unit (30, 50, 100), which is a cassette type unit on which electrical terminals (31, 57, 104) are provided, and a second connector unit (40, 60, 120), which is a holder unit, for holding the first connector unit, in which electrical terminals (42, 158) are provided, the second unit having a mouth (46, 66, 126) into which the first unit is inserted for establishing connection of electrical terminals of the first and second units, the arrangement being such that after insertion into the mouth of the second unit rotation of the first unit in a direction substantially at right angles to the direction of insertion brings about pressure contact between electrical terminals of the first and second units, the second unit having a freely rotatable accommodation case (41, 64, 140), into which the first connector unit enters and is accommodated upon insertion into the second connector unit, which case rotates with the first connector unit when pressure contact between electrical terminals of the first and second unit is being brought about, a locking mechanism (83, 83' 84, 86' 88, 89, 76, 95, 96; 155, 156, 143) adapted to lock the accommodation case in position in the second unit when pressure contact between electrical terminals is brought about, and a push button (72, 122) on the second unit operable to unlock the first unit, characterised in that the freely rotatable accommodation case (41, 64, 140) lies wholly within the second connector unit (40, 60, 120) and rotates relative to the mouth of the second connector unit, the first and second units being so adapted that when accommodated in the accommodation case, ready for rotation, a portion of the first unit projects out of the mouth of the second unit for manipulation to bring about rotation of the first unit.

2. An arrangement as claimed in claim 1, wherein the second connector unit has a mouth cover (130) which covers the mouth thereof when the first connector unit is not inserted therein.

3. An arrangement as claimed in claim 2, wherein the first connector unit has a terminal cover (110) for covering the said electrical terminals thereon, the first and second connector units being adapted such that when the first connector unit is inserted into the mouth of the second connector unit the cover of the first connector unit is opened to expose the electrical terminals thereon.

4. An arrangement as claimed in claim 2 or 3, wherein the mouth cover (130) is mounted on the accommodation case (140).

5. An arrangement as claimed in claim 2, 3 or 4, wherein the terminal cover (110) is urged by spring means (109) to cover the electrical terminals (104) of the first unit but is retractable in a direction opposite to the said direction of insertion, to expose the terminals, and wherein the accommodation case (100) has a portion (142) arranged for engaging the terminal cover (11) upon insertion of the first unit into the second unit to bring about such retraction of the terminal cover (110).

6. An arrangement as claimed in any preceding claim, wherein the locking mechanism comprises a locking lever (83, 155) adapted to engage with the accommodation case (64, 140) to establish a locked condition, when pressure contact between electrical terminals of the first and second units is brought about, and the push button (72, 122) is operable to disengage the locking lever from the accommodation case.

7. An arrangement as claimed in claim 6, wherein the locking lever (83, 155) has opposite ends mounted on respective opposite side parts of the second unit, on opposite sides of its mouth, is swingable about one of those ends away from and towards the mouth, being urged towards the mouth by spring means (86', 156), and has a projection (83') thereon projecting towards the mouth, and wherein the accommodation case has at its mouth end a groove (95) opening away from the mouth, arranged so that upon rotation of the inserted first connector unit to bring about pressure contact between electrical terminals, the projection (83') on the locking lever engages the groove (95) under the urging of the spring means (86'), thereby to bring about the locked condition, the push button (72, 122) being arranged for freeing the projection on the locking lever from engagement in the groove.

8. An arrangement as claimed in any preceding claim, wherein electrical terminals (31, 57, 104) of the first connector unit are provided on an end surface towards that end of the first connector unit which is for insertion first into the mouth of the second connector unit, and electrical terminals (42, 158) of the second connector unit are provided internally thereof remote from the mouth thereof.

9. An arrangement as claimed in any preceding claim, wherein the first connector unit is provided with an L-shaped groove (54) along a side thereof, and the second connector unit is provided with a pin type projection (74) which projects into the mouth thereof, such that when the first connector unit is inserted into the mouth of the second connector unit, the projection engages the groove (the horizontal arm of the "L"), to guide the first connector unit into the mouth, and such that when the first connector unit is fully inserted into the mouth, rotation of the first connector unit engages the projection with the bent portion of the groove (the vertical arm of the "L") to prevent withdrawal of the first connector unit.

10. An arrangement as claimed in any preceding claim, wherein the second connector unit is provided with a window (67) through which a predetermined part (63) of the second connector unit can be seen when, but only when, pressure contact has been established between the electrical terminals of the first and second connector units.

11. An arrangement as claimed in any preceding claim, wherein the electrical terminals of the first and second connector units are provided on respective connector mouldings (105', 153') one of which (105') is provided with an indentation (109) and the other 153') of which is provided with a projection (159), the indentation and the projections interengaging when pressure contact is established, for positive positioning.

12. An arrangement, as claimed in any preceding claim, wherein the first connector unit is a bubble memory unit, comprising a bubble memory element in a housing.

13. A second connector unit as specified in any preceding claim for an electrical connector arrangement as claimed in any preceding claim.

## Revendications

1. Arrangement de connecteur électrique comprenant une première unité de connecteur (30, 50, 100) qui est une unité du type en cassette sur laquelle sont prévues des broches électriques (31, 57, 104) et une seconde unité de connecteur (40, 60, 120) qui est une unité de support pour supporter la première unité de connecteur, dans lequel des broches électriques (42, 158) sont prévues, la sèconde unité comprenant une entrée (46, 66, 126) dans laquelle la première unité est introduite pour l'établissement d'une connexion des broches électriques de la première et de la seconde unités, la disposition étant telle qu'après l'insertion dans l'entrée de la seconde unité, une rotation de la première unité dans une direction pratiquement perpendiculaire à la direction d'introduction établit un contact à pression entre des broches électriques de la première et de la seconde unités, la seconde unité comprenant un boitier de réception (41, 64, 140) pouvant tourner librement dans lequel la première unité de connecteur pénètre et est reçue à l'insertion dans la seconde unité de connecteur, ce boitier tournant avec la première unité de connecteurs quand un contact à pressions entre les broches électriques de la première et de la seconde unités est établi, un mécanisme de verrouillage (83, 83', 84, 86', 88, 89, 76, 95, 96; 155, 156, 143) étant agencé pour verrouiller le boitier de réception en position dans la seconde unité lorsqu'un contact à pression entre des broches électriques est établi et un bouton poussoir (72, 122) sur la seconde unité étant prévu pour déverrouiller la première unité, caractérisé en ce que le boitier de réception (41, 64, 140) pouvant tourner librement se situe entièrement dans la seconde unité de connecteur (40, 60, 120) et tourne par rapport à l'entrée de la seconde unité de connecteur, la première et la seconde unités étant agencées de manière que lorsqu'elle est reçue dans le boitier de réception prête à tourner, une partie de la première unité sort de l'entrée de la seconde unité pour être manipulée et faire tourner la première unité.

2. Arrangement selon la revendication 1, dans lequel la seconde unité de connecteur comporte un couvercle d'entrée (130) qui couvre son entrée quand la première unité de connecteur n'est pas introduite.

3. Arrangement selon la revendication 2, dans lequel la première unité de connecteur comporte un couvercle de broches (110) pour couvrir lesdites broches électriques, la première et la seconde unités de connecteur étant agencées de manière que lorsque la première unité de connecteur est introduite dans l'entrée de la seconde unité de connecteur, le couvercle de la première unité de connecteur s'ouvre pour exposer ces broches électriques.

4. Arrangement selon la revendication 2 ou 3, dans lequel le couvercle d'entrée (130) est monté sur le boitier de réception (140).

5. Arrangement selon la revendication 2, 3 ou 4, dans lequel le couvercle de broches (110) est poussé par un ressort (109) pour couvrir les broches électriques (104) de la première unité mais est rétractable dans une direction opposée à ladite direction d'insertion pour exposer les broches, et dans lequel le boitier de réception (100) comporte une partie (142) agencée pour engager le couvercle de broches (11) à l'insertion de la première unité dans la seconde unité pour produire ce retrait du couvercle de broches (110).

6. Arrangement selon l'une quelconque des revendications précédentes, dans lequel le mécanisme de verrouillage comporte un levier de verrouillage (83, 155) agencé pour engager le boitier de réception (64, 140) pour établir une condition verrouillée quand un contact à pression entre des broches électriques de la première et de la seconde unités est établi, et le bouton poussoir (72, 122) ayant pour fonction de dégager le levier de verrouillage du boitier de réception.

7. Arrangement selon la revendication 6, dans lequel le levier de verrouillage (83, 155) comporte des extrémités opposées montées dans des parties latérales opposées respectives de la seconde unité sur les côtés opposés de son entrée, peut pivoter autour de l'une de ses extrémités à partir et vers l'entrée, en étant rappelé vers l'entrée par un dispositif à ressort (86', 156), et comporte un bossage (83') en saillie vers l'entrée, et dans lequel le boitier de réception comporte à son extrémité de l'entrée une rainure (95) ouverte à l'opposé de l'entrée, agencée de manière que sous l'effet de la rotation de la première unité de connecteur introduite pour établir une pression de contact entre les broches électriques, le bossage (83') sur le levier de verrouillage engage la rainure (95) sous l'effet de la poussée du dispositif à ressort (86') pour l'amener en condition verrouillée, le bouton poussoir (72, 122) étant agencé pour libérer le bossage sur le levier de verrouillage de l'engagement dans la rainure.

8. Arrangement selon l'une quelconque des revendications précédentes, dans lequel des broches électriques (31, 57, 104) de la première unité de connecteur sont prévues sur une surface d'extrémité vers l'extrémité de la première unité de connecteurs qui doit être introduite en premier dans l'entrée de la seconde unité de connecteur et des broches électriques (42, 158) de la seconde unité de connecteur sont prévues à l'interieur, à l'opposé de son entrée.

9. Arrangement selon l'une quelconque des revendications précédentes, dans lequel la première unité de connecteur comporte une rainure (54) en forme de L le long d'un de ses côtés et la seconde unité de connecteur comporte un bossage (74) en forme de goupille en saillie dans son entrée de manière que lorsque la première unité de connecteur est introduite dans l'entrée de la seconde unité de connecteur, le bossage pénètre dans la rainure (le bras horizontal du "L") pour guider la première unité de connecteur dans l'entrée et de manière que lorsque la première unité de connecteur est complètement introduite à l'entrée, une rotation de la première unité de connecteur engage le bossage avec la partie recourbée de la rainure (le bras vertical du "L") pour éviter l'extraction de la première unité de connecteur.

10. Arrangement selon l'une quelconque des revendications précédentes, dans lequel la seconde unité de connecteur comporte un fenêtre (67) par laquelle une partie prédéterminée (63) de la seconde unité de connecteur peur être vue si, et seulement si un contact à pression a été établie entre les broches électriques de la première et de la seconde unités de connecteur.

11. Arrangement selon l'une quelconque des revendications précédentes, dans lequel les broches électriques de la première et de la seconde unités de connecteur sont prévues sur des pièces moulées de connecteurs respectives (105', 153') dont l'une (105') est prévue avec un logement (109) et dont l'autre (153') est prévue avec un bossage (159), le logement et les bossages étant engagés entre eux lorsqu'un contact à pression est établi pour un positionnement positif.

12. Arrangement selon l'une quelconque des revendications précédentes, dans lequel la première unité de connecteur est une unité de mémoire à bulles comprenant un élément de mémoire à bulles dans un boitier.

13. Seconde unité de connecteur selon l'une quelconque des revendications précédentes, pour un arrangement de connecteur tel que revendiqué dans l'une quelconque des revendications précédentes.

## Patentansprüche

1. Elektrische Verbinderanordnung mit einer ersten Verbindereinheit (30, 50, 100), die eine Kassetteneinheit ist und elektrische Anschlüsse (31, 57, 104) aufweist, und einer zweiten Verbindereinheit (40, 60, 120), die eine Halteeinheit ist, um die erste Verbindereinheit zu halten, elektrische Anschlüsse (42, 158) und eine Öffnung (46, 66, 126) aufweist, in die die erste Einheit eingeführt wird, um die Verbindung der elektrischen Anschlüsse der beiden Einheiten herzustellen,

wobei die Anordnung so getroffen ist, daß nach Einführen in die Öffnung der zweiten Einheit ein Rotation der ersten Einheit, in einer Richtung im wesentlichen rechtwinklig zu dur Einführungsrichtung, einen Druckkontakt zwischen elektrischen Anschlüssen der ersten und der zweiten Einheit herstellt, die zweite Einheit ein frei rotierbares Aufnahmegehäuse (41, 64, 140) hat, in welches die erste Verbindereinheit eintritt und nach Einführung in die zweite Verbindereinheit aufgenommen wird, welches Gehäuse mit der ersten Verbindereinheit rotiert, wenn Druckkontakt zwischen den elektrischen Anschlüssen der ersten Einheit und der zweiten Einheit hergestellt wird,

und mit einem Riegelmechanismus, (83, 83', 84, 86', 88, 89, 76, 95, 96; 155, 156, 143), der zur Verriegelung des Aufnahmegehäuses in einer Position in der zweiten Einheit ausgebildet ist, wenn Druckkontakt zwischen den elektrischen Anschlüssen hergestellt worden ist, und einem Druckknopf (72, 122) auf der zweiten Einheit, der zur Entriegelung der ersten Einheit dient, dadurch gekennzeichnet,

daß das frei rotierbare Aufnahmegehäuse (41, 64, 140) vollständig innerhalb der zweiten Verbindereinheit (40, 60, 120) liegt und relativ zu der Öffnung der zweiten in Verbindereinheit rotiert, und die erste und die zweite Einheit so ausgebildet sind, daß bei Aufnahme in dem Aufnahmegehäuse, bereit zur Rotation, ein Teil der ersten Einheit aus der Öffnung der zweiten Einheit zur Manipulierung vorsteht, um die Rotation der ersten Einheit zu bewirken.

2. Anordnung nach Anspruch 1, bei der die zweite Verbindereinheit eine Öffnungsabdeckung (130) hat, die die Öffnung abdeckt, wenn die erste Verbindereinheit nicht in sie eingeführt ist.

3. Anordnung nach Anspruch 2, bei die erste Verbindereinheit eine Anschlußabdeckung (110) zur Abdeckung der an ihr befindlichen Anschlüsse hat, und die erste und die zweite Verbindereinheiten so ausgebildet sind, daß dann, wenn die erste Verbindereinheit in die Öffnung der zweiten Verbindereinheit eingeführt wird, die Abdeckung der ersten Verbindereinheit geöffnet wird, um deren elektrische Anschlüsse zu exponieren.

4. Anordnung nach Anspruch 2 oder 3, bei der die Öffnungs abdeckung (130) auf dem Aufnahmegehäuse (140) angeordnet ist.

5. Anordnung nach Anspruch 2, 3 oder 4, bei der die Anschlußabdeckung (110) durch eine Federeinrichtung (109) vorgespannt wird, um die elektrischen Anschlüsse (104) der ersten Einheit abzudecken, jedoch in einer Richtung entgegengesetzt zu der genannten Einführungsrichtung zurückziehbar ist, um die Anschlüsse zu exponieren, und bei der das Aufnahmegehäuse (100) einen Abschnitt (142) aufweist, der zum Eingriff der Anschlußabdeckung (11) bei Einführung der ersten Einheit in die zweite Einheit ausgebildet ist, um solch eine Rückziehung der Anschlußabdeckung (100) zu bewirken.

6. Anordnung nach einem der vorhergehenden Ansprüche, bei der der Riegelmechanismus einen Verriegelhebel (83, 155) umfaßt, der zum Eingriff mit dem Aufnahmegehäuse (64, 140) ausgebildet ist, um einen Verriegelungszustand herzustellen, wenn Druckkontakt zwischen den elektrischen Anschlüssen der ersten und der zweiten Einheit hergestellt worden ist, und der Druckknopf (72, 122) betätigbar ist, um den Verriegelhebel von dem Aufnahmegehäuse zu lösen.

7. Anordnung nach Anspruch 6, bei der der Verriegelungshebel (83, 155) mit seinen entgegengesetzten Enden an entsprechend entgegengesetzten Seitenteilen der zweiten Einheit, auf den der Öffnung gegenüberliegenden Seiten befestigt und um eines dieser Enden von der Öffnung fort und zu ihr hin verschwenkbar ist, und durch Federeinrichtungen (86, 156) zu der Öffnung hin vorgespannt wird, und einen Vorsprung (83') aufweist, der zu der Öffnung hin vorsteht,

und bei welcher das Aufnahmegehäuse an seinen Öffnungsende eine Nut (95) aufweist, die sich von der Öffnung fort öffnet, und so angeordnet ist, daß bei Rotation der eingeführten ersten Verbindereinheit Druckkontakt zwischen den elektrischen Anschlüssen hergestellt wird,

der Vorsprung (83') auf dem Verriegelungshebel mit der Nut (95) unter der Vorspannung der Federeinrichtung (86') zum Eingriff kommt, wodurch der Verriegelungszustand hergestellt wird,

und der Druckknopf (72, 122) so angeordnet ist, daß er den Vorsprung auf dem Verriegelungshebel aus dem Eingriff mit der Nut befreit.

8. Anordnung nach einem der vorhergehenden Ansprüche, bei der die elektrischen Anschlüsse (31, 57, 104) der ersten Verbindereinheit auf einer Endoberfläche vorgesehen sind, die dem Ende des ersten Verbindereinheit zugewandt ist, die zur Einführung zuerst in die Öffnung der zweiten Verbindereinheit dient, und elektrische Anschlüsse (42, 158) der zweiten Verbindereinheit innerhalb derselben, entfernt von der Öffnung derselben, vorgesehen sind.

9. Anordnung nach einem der vorhergehenden Ansprüche, bei der die erste Verbindereinheit eine L-förmige Nut (54) an ihrer einen Seite aufweist, und die zweite Verbindereinheit einen nadelartigen Vorsprung (74) aufweist, der in die Öffnung vorsteht, so daß dann, wenn die erste Verbindereinheit in die Öffnung der zweiten Verbindereinheit eingeführt wird, der Vorsprung in die Nut (der L-förmige horizontale Arm) eingreift,

um die erste Verbindereinheit in die Öffnung zu führen, und daß dann, wenn die erste Verbindereinheit vollständig in die Öffnung eingeführt ist, die Rotation der ersten Verbindereinheit den Eingriff des Vorsprungs in den gebogenen Abschnitt der Nut (der vertikale Arm von dem "L") bewirkt, um ein Zurückziehen der ersten Verbindereinheit zu verhindern.

10. Verbinderanordnung nach einem der vorhergehenden Ansprüche, bei der die zweite Verbindereinheit ein Fenster (67) aufweist, durch das ein vorbestimmtes Teil (63) der zweiten Verbindereinheit dann und nur dann gesehen werden kann, wenn Druckkontakt zwischen den elektrischen Anschlüssen der ersten und der zweiten Verbindereinheit hergestellt ist.

11. Anordnung nach einem der vorhergehenden Ansprüche, bei der die elektrischen Anschlüsse der ersten und der zweiten Verbindereinheiten an entsprechenden Verbinderformteilen (105', 153') vorgesehen sind, von denen eines (105') eine Vertiefung (109) und das andere (153') einen Vorsprung (159) aufweist, und die Vertiefungen und die Vorsprünge, wenn Druckkontakt hergestellt ist, für eine zwangsweise Positionierung ineinandergreifen.

12. Anordnung nach einem der vorhergehenden Ansprüche, bei der die erste Verbindereinheit eine Blasenspeichereinheit ist, die in einem Gehäuse ein Blasenspeicherelement umfaßt.

13. Zweite Verbindereinheit nach einem der vorhergehenden Ansprüche, für eine elektrische Verbinderanordnung nach einem der vorhergehenden Ansprüche.

Fig. 1

Fig. 2

1

Fig. 3

2

Fig. 4

30
31

Fig. 5

44    43    42
46    40
41    45

Fig. 6

30    42
A    31
41    40

Fig. 7

P
44    43    42
B    31
B
30    41    44    40

3

Fig. 8

# 0 045 189

*Fig. 9*

Fig. 10

Fig. 11

Fig. 12

Fig. 13

Fig. 14

Fig. 15B

Fig. 15A

Fig. 16B

Fig. 16A

**0 045 189**

*Fig. 17*

Fig. 18

Fig. 19A

Fig. 20A

Fig. 19B

Fig. 20B

Fig. 21

Fig. 22

Fig. 23

Fig. 24A

Fig. 24B